# EUROPEAN PATENT APPLICATION

(11) **EP 4 579 127 A1**
(43) Date of publication of application: **02.07.2025**
(21) Application number: 23460044.3
(22) Date of filing: 27.12.2023
(51) Int. Cl.: F21V 29/56, F21V 29/83, H05K 7/20

(54) **COOLING ARRANGEMENT, COOLING UNIT, COOLING SYSTEM, ELECTRONIC DEVICE AND HIGH POWER GENERATOR**

(71) Applicant: TRUMPF Huettinger Sp. Z o. o., 05-220 Zielonka (PL)
(72) Inventor: KLIMCZAK, Andrzej, 01-633 Warsaw (PL); GIERALTOWSKI, Andrzej, 02-786 Warszawa (PL); KOSEWSKI, Lukasz, 05-120 Legionowo (PL); BALCERAK, Michal, 05-270 Marki (PL)
(74) Representative: Trumpf Patentabteilung

(57) **Abstract**

Cooling arrangement (1) for passive direct liquid cooling, comprising:
a) a wall (2),
b) a cooling channel (3),
c) an upper opening (4),
d) a lower opening (5),
e) whereby the wall (2) surrounds the cooling channel (3),
f) whereby the cooling channel (3) connects the upper opening (4) with the lower opening (5),
g) whereby the cooling arrangement (1) is designed:
to be arranged on a heat sink (6) and in a cooling liquid (7) and to cool the
cooling liquid (7) and thereby lift it in the cooling channel (3) from top to
bottom, so that a temperature gradient from top to bottom is created.

Disclosed is also a cooling unit (10), comprising such a cooling arrangement (1), a cooling system (100) comprising such a cooling unit (10), an electronic device (1000), comprising such a cooling system (100), an HP-generator for plasma processing, and a plasma processing system (1002).

## Description

The present invention relates to a cooling arrangement for passive liquid cooling, a cooling unit and a cooling system.

In one aspect, the invention relates to an electronic device comprising a plurality of electrical components generating heat, in particular a high power (HP) generator, especially a HP pulsed power supply for plasma processing, said electronic device comprising:
- a container, wherein said plurality of electrical components are placed,
- an electrically insulating heat transfer liquid, filled within said container and having direct contact to the electrical components to transport heat away from those electrical components and to enhance the electrical insulation between those electrical components in comparison to the electrical insulation of air.

Heat is generated in most electronic applications during operation. This heat affects operation and can cause damage to the electronic applications. Electronic applications can be, for example, electronic applications that use printed circuit boards (PCBs). These PCBs may be populated, for example, with components such as capacitors, inductors, resistors, and semiconductor devices.

It is usually useful to dissipate the heat generated in the electronic applications. Cooling systems can be used to dissipate the heat, e.g., cooling systems that dissipate the heat generated via a cooling liquid to a heat sink.

In electronic applications with PCBs, it can be useful to arrange the PCBs in a cooling chamber and to fill the cooling chamber with a cooling liquid. The PCBs are then surrounded by the cooling liquid. Such cooling is also known as direct liquid cooling (DLC).

Another electronic application may be a high-power generator that needs cooling. In EP4235738A1 the advantageous use of a direct liquid cooling for such a high-power generator is described. By using direct liquid cooling, clearance and creepage requirements can be reduced. This allows better utilization of the safe operating range of all components, resulting in a size reduction and thus a reduction in parasitic reactance, such as e.g., capacity and/or inductivity. Thus, a smaller high-power generator and increased efficiency can be achieved through direct liquid cooling.

In general, the cooling fluid of a direct liquid cooling system should be a dielectric cooling liquid that does not negatively affect the function of the electronic application to be cooled.

In such a device, where an electronic application is placed in cooling liquid, the heat generated by the application is transferred to the cooling liquid. This cooling liquid usually transfers its heat to a heat sink. It is therefore important to ensure good circulation of the cooling liquid so that the cooling liquid can dissipate the heat generated.

If the cooling liquid heats up, it rises to the top of the cooling chamber. It would therefore make sense to place a heat sink at the top of the cooling chamber. However, since all other gases in the cooling chamber, such as air bubbles or steam, also rise to the top of the cooling chamber, a thermally insulating layer forms between the cooling liquid and the top of the cooling chamber, so placing a heat sink on the top of the cooling chamber is often ineffective.

To still be able to dissipate the heat, a cooling chamber is often divided into many small cooling chambers with individual walls through which the heat can be dissipated. Pumps can also be used, for example, to circulate the cooling liquid so that a heat sink can be placed at a different location.

However, these solutions always mean a lot of extra work. Many individual walls limit the space for electronic applications to be cooled. The use of pumps is itself energy-intensive and, also means extra work outside the cooling chamber for the arrangement of a pump's motor and control, for example. In one aspect such mechanical driven moving parts may have a limited lifetime.

The present invention is therefore based on the task of providing a cooling arrangement which on the one hand makes passive direct liquid cooling possible and on the other hand does not restrict the size of the cooling chamber.

This task is solved by the cooling arrangement for passive direct liquid cooling according to independent claim 1. Further advantageous embodiments result from the subclaims and/or the description.

In accordance with the present invention, a cooling arrangement for passive direct liquid cooling is proposed, comprising:
a) one wall,
b) one cooling channel,
c) an upper opening,
d) a lower opening,
e) whereby the wall surrounds the cooling channel,
f) whereby the cooling channel connects the upper opening with the lower opening,
g) whereby the cooling arrangement is designed to
   i) be arranged on a heat sink and in a cooling liquid and
   ii) to cool the cooling liquid and thereby lift it in the cooling channel from top to bottom, so that a temperature gradient from top to bottom is created.

When using this cooling arrangement according to the invention, the cooling arrangement could be cooled, e.g., by a heat sink on which it is arranged. This has the effect that the cooling arrangement cools down the cooling liquid that is in its cooling channel. The cooling of the cooling liquid increases its density, and the cooling liquid is lifted from top to bottom in the cooling channel. This creates a flow of cooling fluid from the upper to the lower opening of the cooling arrangement. In this way, the cooling fluid flow may get a temperature gradient from top to bottom.

In such a way, a cooling arrangement may be provided that enables passive circulation of the cooling liquid in a cooling chamber and thereby cools the cooling liquid. "Passive" means here that the cooling arrangement does work without any additional energy input and without mechanical driven moving parts. In addition, this cooling arrangement does not limit the size of a cooling chamber.

The cooling arrangement can comprise good heat-conducting material, such as ceramic, copper and/or aluminum. Good heat conduction of the cooling arrangement allows the cooling liquid to be cooled efficiently.

In an aspect, the wall thickness of the wall of the cooling arrangement increases from top to bottom. The cooling arrangement can be frustoconical, for example.

Thus, a better heat transfer along the cooling arrangement can be achieved and the temperature of the cooling channel is relatively low along the entire length of the cooling channel.

The cooling arrangement can be arranged in a cooling unit. The cooling unit can comprise one or more cooling arrangements and a heat sink, on which the cooling arrangements are arranged. The heat sink can preferably be a metallic heat sink, e.g., made of copper and/or aluminum. The heat sink may have a cooling channel through which a cooling fluid can flow, which dissipates the heat of the heat sink. This cooling fluid need not be a dielectric cooling fluid. It can be water, for example. This also includes distilled water.

The heat sink may also be a substrate, at least partly made of an electrically insulating material such as ceramic or resin-based material, such as used for printed circuit boards (PCBs), e.g.. This could for example be FR4-material.

In this way, the cooling arrangement may be placed in proximity of heat generating electronic parts, placed on such a substrate and forcing the liquid flow next to those electronic parts.

In an aspect, the cooling arrangement can be part of a cooling system. The cooling system can comprise a cooling arrangement, a cooling chamber, cooling liquid, elements to be cooled and a heat sink. The cooling chamber encloses the cooling fluid, and the cooling arrangement is arranged on the bottom of the cooling chamber. The cooling chamber is arranged on the heat sink. The elements to be cooled are located in the cooling chamber and are also surrounded by the cooling fluid. The elements to be cooled can, for example, be PCBs which are equipped with components such as capacitors, inductors, resistors, and semiconductor components.

In an aspect, the heat sink can form the bottom of the cooling chamber. This allows the whole cooling system to be more compact and the heat can be better transferred to the heat sink.

In an aspect, the cooling system can comprise more than one cooling arrangement. These cooling arrangements can be arranged on the bottom of the cooling chamber or on the heat sink.

In one aspect, an electronic device is disclosed, comprising a plurality of electrical components generating heat. This electronic device may be a high power (HP) generator, especially a HP pulsed power supply for plasma processing. Said electronic device comprising:
- a container, wherein said plurality of electrical components are placed,
- an electrically insulating heat transfer liquid, filled within said container and having direct contact to the electrical components to transport heat away from those electrical components and to enhance the electrical insulation between those electrical components in comparison to the electrical insulation of air
- at least one of the following components as described above or below:
   - a cooling arrangement for passive liquid cooling, or
   - a cooling unit, or
   - a cooling system.

High power shall mean here 10 kW or more during pulse-on-times.

Such a device is disclosed in the European patent application with the application number 23460017.9, filed on 19.05.2023 with the title: "Electronic device and method of cooling thereof". This European patent application is incorporated into this application in its entirety by reference.

Such a device is further disclosed in the European patent application with the application number 23460018.7, filed on 19.05.2023 with the title: "Electronic device and method of cooling thereof". This European patent application is also incorporated into this application in its entirety by reference.

Such a device is further disclosed in the European patent application with the application number 23460016.1, filed on 19.05.2023 with the title: "Electronic device and method of cooling thereof". This European patent application is also incorporated into this application in its entirety by reference.

In one aspect, a HP generator is disclosed, in particular for plasma processing. This HP-generator may be configured to deliver pulsed high power with a high value of voltage and/or high current to a capacitive load, in particular to a plasma process. This HP-generator comprises at least one of such a cooling arrangement for passive liquid cooling, or a cooling unit, or a cooling system.

High power shall mean here 10 kW during pulsing or more. High value of voltage shall mean here 2 kV or more, in particular 4 kV or more. High current shall mean here 10 A or more. The HP-generator may be configured to influence a voltage and/or movement of charge carriers in a plasma and/or between a plasma potential and a substrate in a plasma process. By a capacitive load is meant a load with a capacitive part, which means, that a voltage rise on this load implies a high current capability. The capacitive part may in these cases at least be 100 pF, preferred 200 pF or more, such as around 500 pF. This could be a load in a plasma process as, for example, a plasma treatment application. Some plasma treatment applications, such as etching or layer deposition, demand a high voltage (HV), high frequency (HF), rectangular, asymmetrical, pulsed voltage supply. Often the voltage values significantly exceed the voltage handling possibilities of individual semiconductor switches, especially when high frequency operation is required. Such plasma treatment applications and corresponding high power (HP) generators are described in EP4235738A1, e.g.. EP4235738A1 shall be incorporated in this application in its entirety by reference.

In the following figures are shown:
- Fig. 1a, b, c: a cooling arrangement in three different perspectives;
- Fig. 2a, b: a further cooling arrangement in two different perspectives;
- Fig. 2c, d: a further cooling arrangement in two different perspectives;
- Fig. 3: a cooling unit;
- Fig. 4: a cooling system with a cooling arrangement;
- Fig. 5: an electronic device
- Fig. 6: a further electronic device.
- Fig. 7: a plasma processing system with a plasma chamber.

### Detailed description of the fiaure(s):

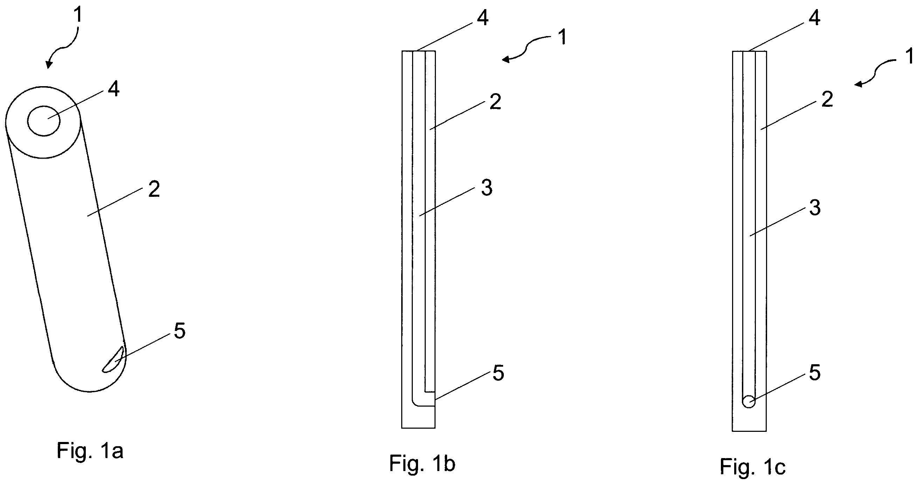

In Figs. 1a, b, c is shown a possible embodiment of a cooling arrangement 1 in three different perspectives. Fig. 1a is a three-dimensional illustration of the cooling arrangement 1. Figs. 1b and c each show the cooling arrangement 1 in two dimensions in cross-section. In Fig. 1b, the lower opening 5 of the cooling arrangement 1 is directed to the right. In Fig. 1c, the lower opening 5 of the cooling arrangement 1 is directed to the front.

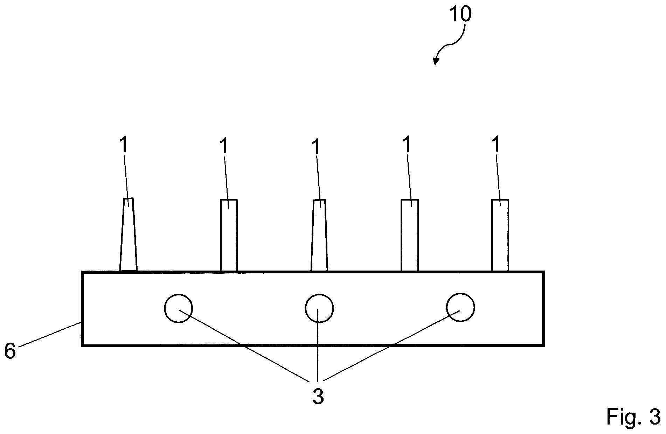

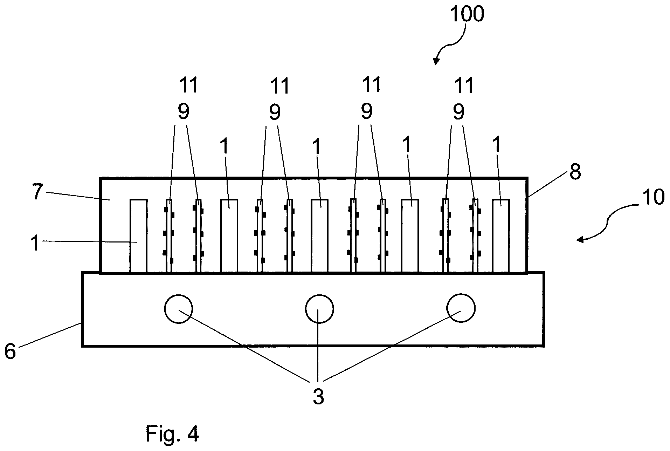

The cooling arrangement 1 comprises a wall 2, a cooling channel 3, an upper opening 4 and a lower opening 5. The wall 2 surrounds the cooling channel 3 or, by arrangement of the wall 2, the cooling channel 3 is formed. The cooling channel 3 connects the upper opening 4 with the lower opening 5. In this embodiment, the upper opening 4 is arranged on the upper side of the cooling arrangement 1. The lower opening 5 is arranged on the side of the cooling arrangement 1, so that the cooling arrangement 1 can be placed on a heat sink 6 as shown in Fig. 3 and 4. The cooling arrangement 1 is adapted to be arranged on a heat sink 6 surrounded by a cooling liquid 7 as shown in Fig. 4. The cooling arrangement 1 is cylindrical in shape, with the cooling channel 3 being arranged in the center of the cylinder, which also has a constant diameter.

As may be seen in Fig. 4, this cooling arrangement 1 arranged in a cooling chamber 8 filled with a cooling liquid 7, passively generates a circulation of the cooling liquid 7 and cools it in the process. "Passively" shall mean here "without mechanical driven moving parts". In the cooling chamber 8, heated cooling liquid 7 rises as its density decreases. At the top of the cooling chamber 8, the cooling liquid 7 then enters the cooling channel 3 via the upper opening 4 of the cooling arrangement 1. The cooling arrangement 1 is cooled by the heat sink 6 on which it is placed. The cooling arrangement 1 thus has a lower temperature than the cooling liquid 7. This cools the cooling liquid 7 in the cooling channel 3, increasing its density and lifts the cooling liquid 7 in the cooling channel 3 from the lower opening 5 to the upper opening 4. This creates a circulation of the cooling liquid 7 in the cooling chamber 8. The heat sink 6, the cooling liquid 7 and the cooling chamber 8 are not shown in the Figs. 1a, b, c.

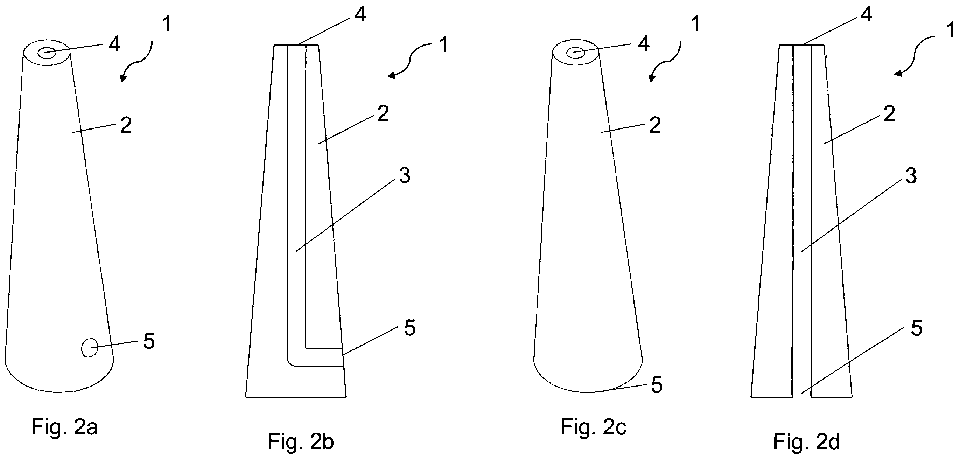

Fig. 2a and b show a further embodiment of a cooling arrangement 1 from two perspectives. Fig. 2a shows the cooling arrangement 1 in a three-dimensional view. Fig. 2b shows the cooling arrangement 1 in two dimensions in cross-section. Overall, this embodiment of the cooling arrangement 1 has the same function and the same components as embodiments of the cooling arrangement 1 in Figs. 1a, b, c, so for the description thereof, reference is made to the description of Figs. 1a, b, c.

The difference between the cooling arrangement 1 in Fig. 1a, b, c and Fig. 2a, b is the shape of the wall 2 of the cooling arrangement 1. This wall 2 increases from top to bottom in Fig. 2a, b. As a result, the cooling arrangement 1 is frustoconical in shape. As in Fig. 1b, c, the diameter of the cooling channel 3 is constant in Fig. 2b.

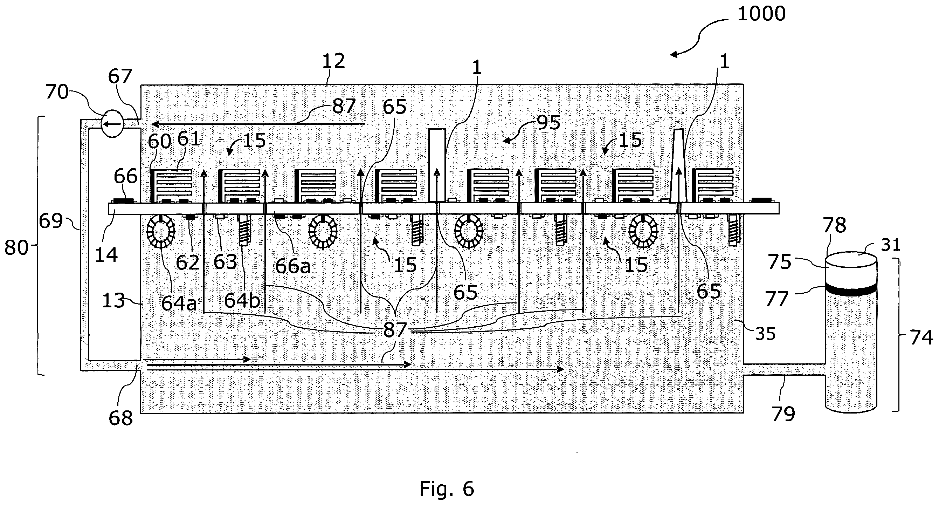

In Fig. 2c, d is shown a further embodiment of a cooling arrangement 1 from two perspectives. The only difference between the cooling arrangement 1 of Fig. 2a, 2b compared to that in Fig. 2c, d is that the cooling channel 3 from the lower opening 5 to the upper opening 4 is straight and the lower opening 5 is on the bottom cross-section of the cooling arrangement 1. This is also possible with a cylindrical cooling arrangement 1 shown in Fig. 1a to 1c. If such a cooling arrangement 1 is placed on a heat sink 6, the heat sink 6 should have an opening, e.g. a culvert, placed in a way to let the liquid through the lower opening 5. Such culverts are, e.g. shown in Fig. 6 with the reference number 65.

Fig.3 shows cooling unit 10. The cooling unit 10 comprises a cooling arrangement 1 which is placed on a heat sink 6. The heat sink 6 has its own cooling channels 3.

Fig. 4 shows a cooling system 100. This cooling system 100 comprises a cooling unit 10 as described above in connection with Fig. 3, e.g.. This cooling system 100 comprises further a cooling chamber 8, cooling liquid 7, and eight elements to be cooled 9. The cooling unit 10 comprises a heat sink 6 and five cooling arrangements 1 as described in this disclosure. The cooling chamber 8 is arranged on the heat sink 6 and the heat sink 6 forms the bottom of the cooling chamber 8. Further, the cooling chamber 8 is filled with the cooling liquid 7. The elements to be cooled 9 and the cooling arrangements 1 are arranged on the heat sink 6, surrounded by the cooling liquid 7 and in the cooling chamber 8. The elements to be cooled 9 are shown as printed circuit boards (PCBs) 11, populated with electronic devices, which generate heat during their operation. This heat is dissipated by the cooling liquid 7, cooling arrangements 1 and heat sink 6 according to the function described above.

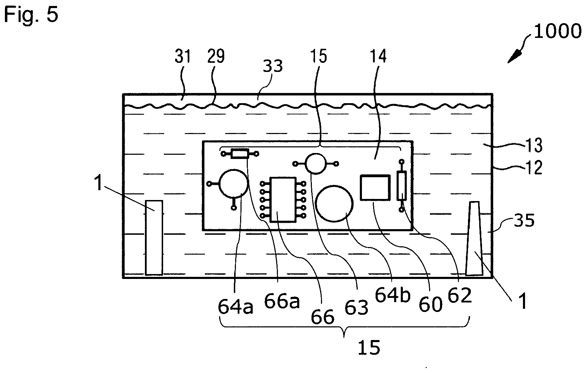

Fig. 5 shows one embodiment of an electronic device 1000. Such an embodiment is also described in more detail in the European patent applications with the application numbers 23460017.9, 23460018.7, and 23460016.1.

The device 1000 comprises a printed circuit board (PCB) 14 which may be the PCB 11 of Fig. 4 or a comparable carrier of electric or electronical components 15. A variety of electric or electronical components 15 are positioned on the PCB 14. Those electric or electronical components 15 could be the "to be cooled elements 9" of Fig. 4. These electronical components 15 may be one or several transistors 60, diodes 66a, one or several resistors 62, one or several capacitors 63, one or several inductors and/or transformers 64a, 64b, or one or more integrated circuits 66, in particular semiconductor based, such as driver circuits for the transistors 60. They may be all part of the electronic device 1000. In this embodiment the whole PCB 14 and all electronical components 15 are positioned inside the container 12. This is not obligatory. It is here and in all other embodiments possible, but it is also possible, that some of the parts 15 are outside the container 12, as it is shown later in Fig. 6, e.g..

A container 12 is filled with a liquid 13. The liquid 13 may be the cooling liquid 7 of Fig. 4. It may be configured as an insulating heat transfer liquid, e.g., such as disclosed by WO 2021/008949 A1 which is herewith fully incorporated by reference in its entirety.

The electronic device 1000 may be any kind of electronic device that requires a high packaging density and requires direct liquid cooling. In particular, the device 1000 may be a high power (HP) and/or high voltage (HV) pulsed power supply, in particular for biasing a substrate in a plasma process, such as known from the EP4235738A1.

The electronic device 1000 may be in particular that part of such a power supply which needs cooling and insulation the most, such as: switching transistors, HV transformers, diodes, and damping circuits comprising inductivities and/or resistors, e.g..

The container 12 may be hermetically closed, so no gas or liquid may leave. Gas solubility of cooling liquids may be controlled by the pressure of the liquid 13. The liquid extends with rising temperature. Thus, some extra volume 31 filled with a compressible medium such as gas above the top level 29 of the liquid 13 is required to allow the increase of second volume 35 of the liquid 13.

Fig. 6 shows a further embodiment of an electronic device 1000. Such an embodiment is also described in more detail in the European patent applications with the application numbers 23460017.9, 23460018.7, and 23460016.1.

The device 1000 comprises a printed circuit board (PCB) 14 which may be the PCB 11 of Fig. 4 or a comparable carrier of electric or electronical components which could be the components 15 of Fig. 5. A variety of those electric or electronical components are positioned on the PCB 14. As in Fig. 5, also here, those electric or electronical components could be the "to be cooled elements 9" of Fig. 4.

The electronic device 1000 comprises a container 12. This container 12 comprises a heat transfer liquid 13, the PCB 14, a circulating device 80, and a pneumatic system 74. As in Fig. 5, also here, the liquid 13 may be the cooling liquid 7 of Fig. 4.

Two of the cooling arrangements 1 are placed inside the container 12 to circulate the liquid. The heat sink 6 is here the PCB 14. The PCB 14 has therefore culverts 65 where the liquid may pass. The cooling arrangements 1 have their bottom openings 5 on the bottom which are placed on the culverts 65 as described in the description according to Fig. 2c, d.

The container 12 is filled with heat transfer liquid 13. The PCB 14 is arranged in the container 12 and surrounded by the heat transfer liquid 13. Further, the PCB 14 is led out of the container 12 on two sides.

The PCB 14 is equipped with various components. These components include transistors 60, heat sinks 61, resistors 62, capacitances 63, inductors 64a, 64b, diodes 66a, and drivers 66. The drivers 66 of the PCB 14 could be arranged outside the container 12 on the PCB 14. In this way they are thus not surrounded by the heat transfer liquid 13. The remaining components are arranged inside the container 12 on the PCB 14 and are thus surrounded by the heat transfer liquid 13. The inductors 64a, 64b are shown in two different embodiments. The heat sinks 61 are each arranged on the transistors 60 and have a plurality of pins. As mentioned, the PCB 14 further comprises several culverts 65. These culverts 65 are designed to allow the heat transfer liquid 13 to flow through. As a result, the heat transfer liquid 13 can flow through the PCB 14, so that above and below the PCB 14 is the same heat transfer liquid 13. For reasons of clarity, only one of the different components are provided with a reference mark. However, the remaining components can also be assigned via the same appearance of the same components.

The electronic device 1000 comprises a liquid guiding equipment 95, configured to guide the electrically insulating heat transfer liquid 13 along at least a part of the plurality of electrical components 15, so that said part of the plurality of electrical components 15 are cooled with the same temperature.

As mentioned before, there could be different solutions of liquid guiding equipment 95, like tubes, pumps, ventilators and so on. The important thing is that those solutions are able to guide the liquid in parallel across those electrical components to cool them with the same temperature. The cooling arrangements 1 could be used as sole liquid guiding equipment. Then, the pump 70, as described in more detail later, will not be necessary. Alternatively, the cooling arrangements 1 could be used as liquid guiding equipment additional to a pump 70. In this case the one or more cooling arrangements 1 may be used to adjust the fluid flow in the container 12.

One possible solution is the liquid guiding equipment is made of a volume with a first pressure on one side of a PCB 14 and a volume with a second pressure on the other side of a PCB 14 and the PCB comprises holes as culverts 65 to guide the liquid in parallel.

The components described and illustrated here are exemplary for the assembly of PCB 14. The PCB 14 may also be equipped with other components, such as diodes 66a.

The circulating device 80 of the container 12 comprises a heat transfer liquid outlet 67, a heat transfer liquid inlet 68, a heat transfer liquid pump 70 and a heat transfer liquid conduit 69. When the heat transfer liquid 13 heats up, the heated heat transfer liquid rises inside the container 12 upwards. Via the heat transfer liquid outlet 67, the heat transfer liquid 13 that has risen upwards can then reach the circulating device 80, in which it can get back into the lower area of the container 12 through the heat transfer liquid pump 70, the heat transfer liquid conduit 69 and the heat transfer liquid inlet 68. Within the circulating device 80, the heat transfer liquid 13 can be cooled down by other devices. Overall, the circulating device 80 thus ensures circulation of the heat transfer liquid 13 within the container 12.

As shown with the arrows 87 the heat transfer liquid 13 flows through the culverts 65 to cool several components also the transistors 60 in parallel, so that they are cooled with more or less the same temperature.

As mentioned earlier, the cooling arrangements 1 could be used as liquid guiding equipment alone without a pump 70 or additional to a pump 70. In the later case, the cooling arrangements 1 could be used to adjust the liquid flow in the container to adjust also the temperature.

As the heat transfer liquid 13 heats up, it expands and the pressure in the container 12 thus increases. The container 12 has a pneumatic system 74 to counteract this pressure increase. The purpose of this pneumatic system 74 is to regulate the pressure within the container 12.

For this purpose, the pneumatic system 74 in Fig. 4 comprises a membrane 76, a gas 75, a pumping device 72 and a gas pressure control 73. The membrane 76 has an elastic material and is arranged above the PCB 14 in the container 12. The membrane 76 is impermeable to the heat transfer liquid 13. For gas 75, the membrane 76 may be permeable from one side, namely from bottom to top. The gas 75 of the pneumatic system 74 is located in the container 12 above the membrane 76. Due to the one-sided gas permeability of the membrane 76, unwanted gas in the heat transfer liquid 13 can pass through the membrane 76 out of the heat transfer liquid 13. As a result, the heat transfer liquid 13 can be less influenced in its function.

When the heat transfer liquid 13 expands, the membrane 76 is pushed upwards and with no change in the volume of the gas 75 in the container 12, the pressure in the container 12 increases. However, via the pumping device 72 and the gas pressure control 73, the volume of the gas 75 in container 12 can be increased or reduced. The pumping device 72 and gas pressure control 73 are connected to the container 12 via the gas outlet 71.

Overall, the pneumatic system 74 can therefore increase or reduce the pressure in the container 12 by increasing or reducing the volume of the gas 75 in the container 12. The pneumatic system 74 has a cylinder 78, a piston 77, gas 75, a pumping device 72 (not shown), and a gas pressure control 73 (not shown).

The pneumatic system 74 is designed in the form of a cylinder 78. The gas 75 of the pneumatic system 74 via which the pressure in the container 12 is regulated, is arranged within the cylinder 78, above the piston 77 and is not located in the container 12. The piston 77 assumes the function of the membrane 76 and can be moved up and down via the volume of gas 75 located in the cylinder 78 in order to change the pressure in the container 12. The pumping device 72 and the gas pressure control 73 may be located at the top of the cylinder 78 (not shown). The cylinder 78 is arranged outside the container 12 and connected via a cylinder conduit 79 to the container 12. Via the cylinder conduit 79, the heat transfer liquid 13 of the container 12 can enter the cylinder 78. The cylinders 78 may have the same material as the container 12.

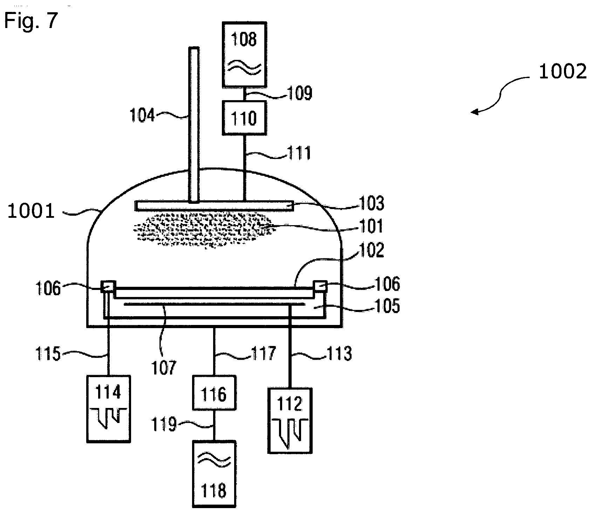

Fig. 7 shows a plasma processing system 1002, in particular a pulsed plasma processing system 1002 with a plasma chamber 1001 in which a plasma 101 is established in a plasma space. Such or similar systems are shown and described also in EP4235738A1, e.g.. For such or a similar system the electronic device 1000 of this description is designed. In the plasma chamber 1001 an upper electrode 103 may be positioned. A gas inlet and/or outlet, in particular a gas supply pipe 104 may be placed from the outside to the inside of the plasma chamber 100, in particular connected to the electrode 103. A substrate 102, in particular a semiconductor wafer may be placed on a support 105 which comprises a substrate holder inside the plasma chamber 1001. In use the substrate 102 may be processed by the plasma 101, e.g., in a process of etching, ashing, or deposition in particular with atomic layered deposition. Etching process may be an extremely high challenge, for instance when the ratio between etched hole diameter and hole length is extremely low, < 1/100, e.g., as it is in deep etching often necessary. An electric conductive electrode 106 may be placed in the plasma chamber 1001, in particular nearby the substrate 102, for example around the substrate 102. This electric conductive electrode 106 may be an edge ring which may be also called focus ring. This electric conductive electrode 106 may be connected to a first power supply 114 via a first connection line 115. The first power supply 114 may be a DC pulsed power supply, where in particular the pulses may be of different length, different amplitude and shaped as described in US 10,474,184 B2, Fig. 2 e.g..

With the control of the first power supply 114 the electric conductive electrode 106 may be used additionally or alternatively as an ion energy and/or ion acceleration direction control as also described in US 10,474,184 B2. A first radio-frequency (RF) power supply 118 may be electrically connected to the support 105 via a first power feeding rod 119 and a first matching unit 116 and a first connection unit 117. A second radio-frequency (RF) power supply 108 may be electrically connected to the upper electrode 103 via a second power feeding rod 109 and a second matching unit 110 and a second connection unit 111. An electrode 107 may be positioned in or nearby the support 105 and is electrically connected to a second power supply 112 via a second connection line 113. The second power supply 112 may be a DC pulsed power supply, where in particular the pulses may be of different length, different amplitude and shaped as described in US 10,474,184 B2, Fig. 2, e.g.. The substrate 102 may be fixed at the support 105 via the electrode 107 which may work as an electrostatic chuck. With the control of the second power supply 112, the electrode 107 may be used additionally or alternatively as an ion energy and/or ion acceleration direction control as described in US 10,474,184 B2.

Some plasma treatment applications, such as etching or layer deposition, demand a high voltage (HV), high frequency (HF), rectangular, asymmetrical, pulsed voltage supply. Often the voltage values significantly exceed the voltage handling possibilities of individual semiconductor switches, especially when high frequency operation is required.

Some plasma applications require not only pulsing, but pulse-to-pulse amplitude variation. Some plasma applications require the source to deliver high peak currents in order to obtain short voltage transition times. Most plasma applications present a load, which contains a capacitive component. Significant power loss is related to the pulse-by-pulse charging and discharging process of this load capacitance. Some plasma applications require pulse shaping as described in US 10,474,184 B2, Fig. 2, e.g..

All described power supplies 104, 112, 114, 118 may be HP-generators as described here and may comprise an electronic device 10 as described in this patent application.

## Claims

1. Cooling arrangement (1) for passive direct liquid cooling, comprising:
a) a wall (2),
b) a cooling channel (3),
c) an upper opening (4),
d) a lower opening (5),
e) whereby the wall (2) surrounds the cooling channel (3),
f) whereby the cooling channel (3) connects the upper opening (4) with the lower opening ( 5),
g) whereby the cooling arrangement (1) is designed:
i) to be arranged on a heat sink (6) and in a cooling liquid (7) and
ii) to cool the cooling liquid (7) and thereby lift it in the cooling channel (3) from top to bottom, so that a temperature gradient from top to bottom is created.

2. Cooling arrangement (1) according to claim 1, whereby the cooling arrangement (1) is comprising a heat-conducting material, such as copper and/or aluminum.

3. Cooling arrangement (1) according to claim 1 or 2, whereby the wall thickness of the wall (2) increases from top to bottom, e. g. frustoconical.

4. Cooling unit (10), comprising:
a) one or more cooling arrangement (1) according to one of the preceding claims,
b) one heat sink (6),
c) where the cooling arrangements (1) are arranged on the heat sink (6).

5. Cooling system (100), comprising:
a) one cooling arrangement (1) according to one of the claims 1 -3,
b) a cooling chamber (8),
c) a cooling liquid (7),
d) elements (9) to be cooled,
e) a heat sink (6),
f) whereby the cooling chamber (3) encloses the cooling fluid (7),
g) whereby the cooling arrangement (1) is arranged on the bottom of the cooling chamber (8), and
h) whereby the cooling chamber (8) is arranged on the heat sink (6).

6. Cooling system (100) according to claim 5, whereby the heat sink (6) forms the bottom of the cooling chamber (8).

7. Cooling system (100) according to claim 5 or 6, whereby the cooling system (100) comprises more than one cooling arrangement (1) which are arranged on the bottom of the cooling chamber (8) or on the heat sink (6).

8. Electronic device (1000), comprising:
- a plurality of electrical components (15) generating heat,
- a container (12), wherein said plurality of electrical components (15) are placed,
- an electrically insulating heat transfer liquid (13), filled within said container (12) and having direct contact to the electrical components (15) to transport heat away from those electrical components (15) and to enhance the electrical insulation between those electrical components (15) in comparison to the electrical insulation of air,
- at least one of the following components:
• cooling arrangement (1) for passive liquid cooling according to one of the claims 1 to 3, or
• a cooling unit (10) according to claim 4, or
• a cooling system (100) according to one of the claims 5 to 7.

9. High power (HP) generator for plasma processing, in particular a pulsed HP-generator for a pulsed plasma processing system (1002), comprising an electronic device (1000) according to claim 8.

10. Plasma processing system (1002) comprising:
- one ore more power supplies (104, 112, 114, 118), where at least one of them is build as an HP-generator according to claim 9,
- a plasma chamber (1001) in which a plasma (101) is established,
- the power supplies (104, 112, 114, 118) are connected to an electrode (103, 106, 107) in the plasma chamber (1001).
